# EUROPEAN PATENT APPLICATION

(11) **EP 2 639 277 A1**
(43) Date of publication of application: **18.09.2013**
(21) Application number: 12159227.3
(22) Date of filing: 13.03.2012
(51) Int. Cl.: C09J 7/02, C09J 5/06, H01L 21/56

(54) **Heat-resistant pressure-sensitive adhesive tape for production of semiconductor device and method for producing semiconductor device using the tape**

(71) Applicant: Nitto Denko Corporation, Ibaraki-shi, Osaka (JP)
(72) Inventor: Soejima, Kazuki, Ibaraki-shi, Osaka (JP); Hoshino, Shinji, Ibaraki-shi, Osaka (JP); Hirayama, Takamasa, Ibaraki-shi, Osaka (JP); Kiuchi, Kazuyuki, Ibaraki-shi, Osaka (JP)
(74) Representative: Grünecker, Kinkeldey, Stockmair & Schwanhäusser

(57) **Abstract**

The present invention provides a heat-resistant pressure-sensitive adhesive tape for the production of a semiconductor device, including a base material layer and a pressure-sensitive adhesive layer formed on each side of the base material layer, in which at least the pressure-sensitive adhesive layer at a side on which a semiconductor chip is to be encapsulated with a resin contains a silicone pressure-sensitive adhesive. The heat-resistant pressure-sensitive adhesive tape is used for temporarily fixing a chip in a method for producing a substrateless semiconductor package which does not use a metal lead frame.

In a preferred embodiment the pressure-sensitive adhesive layer at a side on which a semiconductor chip is not to be encapsulated with a resin comprises a heat-expandable pressure-sensitive adhesive containing heat-expandable micro spheres.

In another preferred embodiment the ratio of a silicone rubber to a silicone resin in the silicone pressure-sensitive adhesive is from 95/5 to 20/80.

## Description

### FIELD OF THE INVENTION

The present invention relates to a heat-resistant pressure-sensitive adhesive tape for the production of a semiconductor device, which is used for temporarily fixing a chip in a method for producing a substrateless semiconductor package which does not use a metal lead frame; and a method for producing a semiconductor device using the tape.

### BACKGROUND OF THE INVENTION

In recent years, CSP (Chip Size/Scale Package) technique is noted in a mounting technology of LSI. Of the technology, a package in a form where a substrate is not used and only a chip is used, that is represented by WLP (Wafer Level Package), is one of package forms particularly noted in terms of size reduction and high integration. According to a production method of WLP, plural semiconductor Si wafer chips arranged in an orderly manner without using a substrate are en bloc encapsulated with an encapsulation resin, and then divided into individual structures by cutting, whereby a smaller-sized package than the conventional package using a substrate can be efficiently produced.

Such a production method of WLP is required to fix a chip conventionally fixed to a substrate on a separate support. Furthermore, the fixation must be released after molding into an individual package through resin encapsulation. Therefore, the support should not be permanently adhered, but must be repeelable. From this point, there is a technique of using a pressure-sensitive adhesive tape as a support for temporarily fixing the chip.

Patent Document 1: JP-A-2001-308116
Patent Document 2: JP-A-2001-313350

### SUMMARY OF THE INVENTION

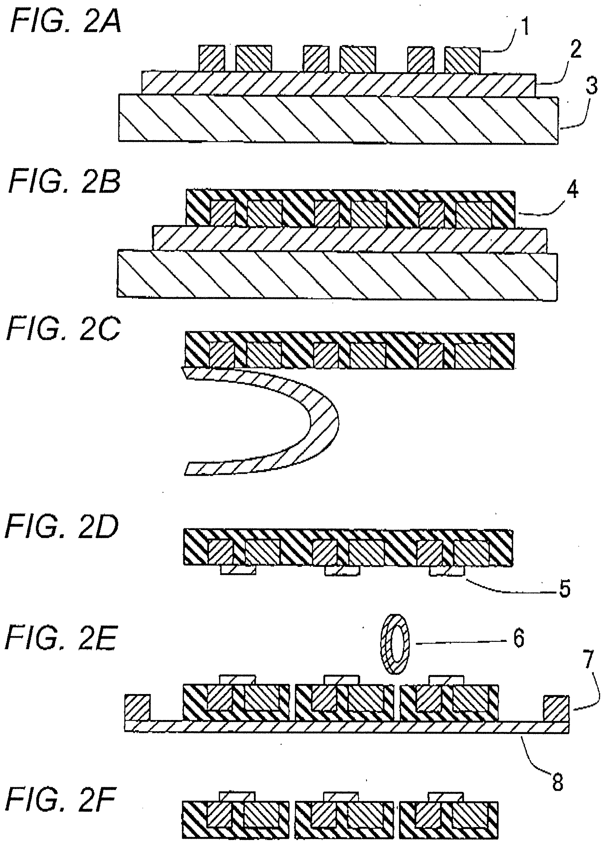

Problems to be solved by the present invention are described below with reference to Figs. 2A to 2F showing a method for producing a substrateless semiconductor device.
Plural chips 1 are adhered to a heat-resistant pressure-sensitive adhesive tape 2 for the production of a semiconductor device, which has pressure-sensitive adhesive layers on both sides thereof, and the heat-resistant pressure-sensitive adhesive tape 2 for the production of a semiconductor device is fixed to a substrate 3 to form a structure as shown in Fig. 2A. Alternatively, the heat-resistant pressure-sensitive adhesive tape 2 for the production of a semiconductor device is adhered to the substrate 3, and the chips 1 are then fixed to the tape 2 to form a structure shown in Fig. 2A.

The chips 1 having the structure shown in Fig. 2A are encapsulated with an encapsulation resin 4 from the upper of the chips 1 so as to integrate plural chips 1 to form a structure shown in Fig. 2B.
Then, as shown in Fig. 2C, plural chips 1 encapsulated with the encapsulation resin 4 is obtained by a method of separating the plural chips 1 encapsulated with the encapsulation resin 4 from the integrated product of the heat-resistant pressure-sensitive adhesive tape 2 for the production of a semiconductor device and the substrate 3, or a method of peeling an assembly including the plural chips 1 encapsulated with the encapsulation resin 4 and the heat-resistant pressure-sensitive adhesive tape 2 for the production of a semiconductor device from the substrate and then peeling only the heat-resistant pressure-sensitive adhesive tape 2 for the production of a semiconductor device from the encapsulated chips.

An electrode 5 is formed on a necessary area on the surface of the chip 1 at a side of the plural chips 1 encapsulated with the encapsulation resin 4, on which the heat-resistant pressure-sensitive adhesive tape 2 for the production of a semiconductor device was provided and the surface of the chip 1 is exposed, thereby forming a structure shown in Fig. 2D.
Then, a dicing tape 8 optionally having a dicing ring 7 at an encapsulation resin side is adhered to the structure to fix plural chips 1 encapsulated with the encapsulation resin 4 for the purpose of a dicing step. The resulting assembly is subjected to dicing with a dicing blade 6 as shown in Fig. 2E, thereby finally obtaining plural substrateless packages each having plural chips encapsulated with the resin, as shown in Fig. 2F.

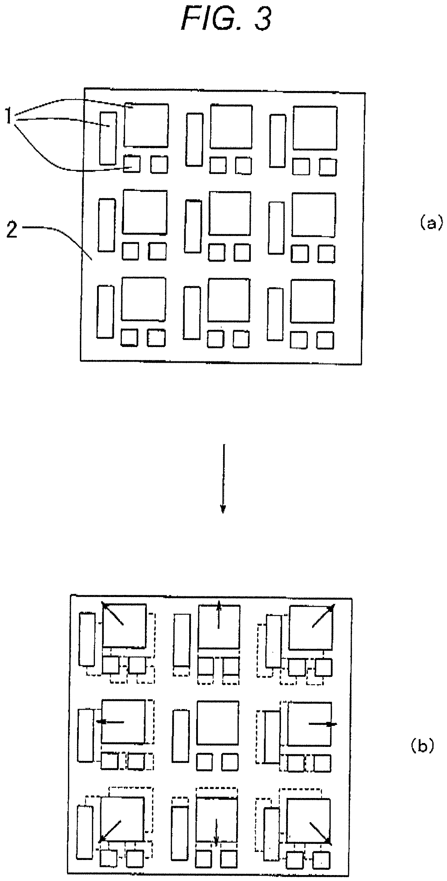

In encapsulating with a resin, there is a case where the heat-resistant pressure-sensitive adhesive tape 2 for the production of a semiconductor device shown in (a) of Fig. 3 deforms in a planar direction as shown in (b) of Fig. 3 due to expansion and elasticity of a base material layer and a pressure-sensitive adhesive layer of the heat-resistant pressure-sensitive adhesive tape 2 for the production of a semiconductor device, whereby the position of the chip 1 provided on the heat-resistant pressure-sensitive adhesive tape 2 for the production of a semiconductor device may move in some cases.
As a result, in providing an electrode on the chip 1, relative positional relationship between the chip and the electrode differs from the predetermined positional relationship. Furthermore, in encapsulating the chip 1 with a resin and subsequent dicing, a dicing line in a dicing step that has been previously determined based on the predetermined position of the chip 1 differs from a dicing line that becomes necessary by the actual position of the chip 1.
In such a case, each package obtained by dicing generates deviation at the position of the chip encapsulated, and the subsequent step cannot advance smoothly. Furthermore, a package which is not sufficiently encapsulated may undesirably be obtained.

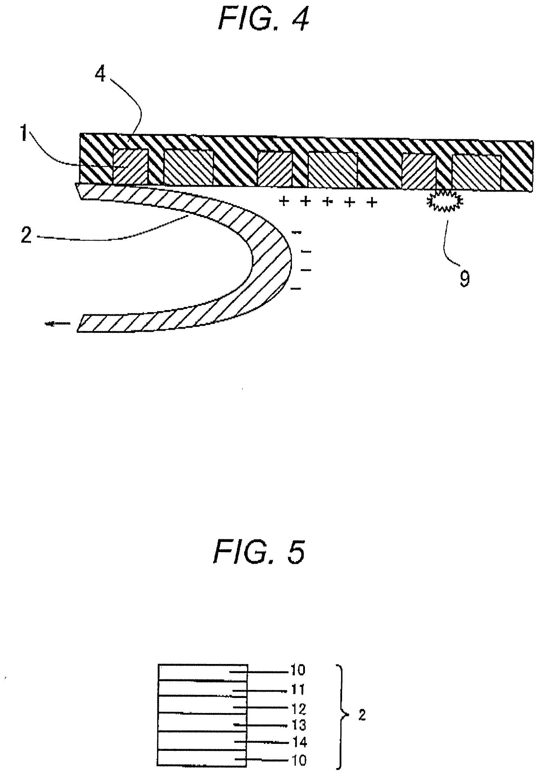

In peeling the heat-resistant pressure-sensitive adhesive tape 2 for the production of a semiconductor device from the chip encapsulated with a resin, particularly depending on the properties of a pressure-sensitive adhesive formed at the chip side of the heat-resistant pressure-sensitive adhesive tape 2 for the production of a semiconductor device, the tape has heavy peelability. Therefore, there is a concern that peeling becomes difficult, an adhesive remains as shown in Fig. 4, or peel charging occurs.
Where peeling becomes difficult, time for peeling is prolonged, resulting in deterioration of productivity due to the heavy peelability. Where an adhesive 9 remains as shown in Fig. 4, the subsequent step such as formation of an electrode cannot be carried out. Furthermore, where peel discharging is generated, disadvantage may occur in the subsequent step due to adhesion of dusts and the like.

As mentioned above, in the method for producing a substrateless semiconductor package using a pressure-sensitive adhesive tape, the chip is not held by the tape due to the pressure when encapsulating with a resin, and deviates from the designated position. Alternatively, the heat-resistant pressure-sensitive adhesive tape for the production of a semiconductor device may become strongly adhered to the chip face or encapsulation resin face due to curing of an encapsulation resin and heat and the package may break in peeling the tape.

The present invention provides a heat-resistant pressure-sensitive adhesive tape for the production of a semiconductor device, which is to be used by being adhered to a substrateless semiconductor chip for temporarily fixing the chip in encapsulating the chip with a resin, the tape comprising a base material layer and a pressure-sensitive adhesive layer formed on each side of the base material layer, wherein at least the pressure-sensitive adhesive layer at a side on which a semiconductor chip is to be encapsulated with a resin comprises a silicone pressure-sensitive adhesive.
In one preferred embodiment, the pressure-sensitive adhesive layer at a side on which a semiconductor chip is not to be encapsulated with a resin contains a heat-expandable pressure-sensitive adhesive containing heat-expandable microspheres.
In another preferred embodiment, a ratio of a silicone rubber to a silicone resin in the silicone pressure-sensitive adhesive is from 95/5 to 20/80.
In still another preferred embodiment, the silicone pressure-sensitive adhesive in the pressure-sensitive adhesive layer at a side on which a semiconductor chip is to be encapsulated with a resin has a 180° peel adhesive force to SUS304BA sheet at 175°C of 0.2 N/20 mm or more.
In still another preferred embodiment, the silicone pressure-sensitive adhesive in the pressure-sensitive adhesive layer at a side on which a semiconductor chip is to be encapsulated with a resin has a 180° peel adhesive force to an encapsulation resin after heating at 175°C of 5.0 N/20 mm or less.
In addition, the present invention also provides a method for producing a substrateless semiconductor device which does not use a metal lead frame, the method comprising using the above-mentioned heat-resistant pressure-sensitive adhesive tape for the production of a semiconductor device.
In one preferred embodiment, the method includes:
(A) a step of adhering a support to the surface of the heat-expandable pressure-sensitive adhesive layer of the pressure-sensitive adhesive tape and adhering an adherend to the surface of the silicone pressure-sensitive adhesive layer;
(B) a step of processing the adherend;
(C) a step of peeling the pressure-sensitive adhesive tape from the support by a heat treatment; and
(D) a step of peeling the pressure-sensitive adhesive tape from the adherend after processing.

The present invention provides a heat-resistant pressure-sensitive adhesive tape for the production of a semiconductor device, which is a pressure-sensitive adhesive tape used for temporarily fixing a chip in a production method of a substrateless semiconductor device which does not use a metal frame (for example, a production method of WLP), wherein the tape is free from the disadvantage that the chip is not held by the tape and deviates from the designated position due to pressure in resin encapsulation, and the tape can be light-peeled after the use without occurrence of adhesive residue to an encapsulation resin after encapsulation.

### BRIEF DESCRIPTION OF THE DRAWINGS

Fig. 1 is a flow chart showing steps of producing a substrateless BGA using the heat-resistant pressure-sensitive adhesive tape for the production of a semiconductor device of the present invention.
Figs. 2A to 2F are schematic views showing a production method of a substrateless package.
Fig. 3 is a view showing that a heat-resistant pressure-sensitive adhesive tape for the production of a semiconductor device, having a chip mounted thereon deforms by heat when encapsulating with an encapsulation resin.
Fig. 4 is a view showing occurrence of charging and adhesive residue in peeling the heat-resistant pressure-sensitive adhesive tape for the production of a semiconductor device.
Fig. 5 is a cross-sectional view of the heat-resistant pressure-sensitive adhesive tape for the production of a semiconductor device of the present invention.

### Description of Reference Numerals and Signs

1: Chip
2: Heat-resistant pressure-sensitive adhesive tape for production of semiconductor device
3: Substrate
4: Encapsulation resin
5: Electrode
6: Dicing blade
7: Dicing ring
8: Dicing tape
9: Adhesive residue
10: Smooth release sheet
11: Silicone pressure-sensitive adhesive layer
12: Supporting base material layer
13: Rubbery organic elastic layer
14: Heat-expandable pressure-sensitive adhesive layer
15: Terminal

### DETAILED DESCRIPTION OF THE INVENTION

As a result of various investigations on material, constitution and the like of a heat-resistant pressure-sensitive adhesive tape for the production of a semiconductor device in order to overcome the above problems, the present inventors have found that the above problems can be overcome by using a heat-resistant pressure-sensitive adhesive tape for the production of a semiconductor device, having a pressure-sensitive adhesive layer containing a silicone pressure-sensitive adhesive, and have reached to complete the present invention.

Namely, the present invention relates to a heat-resistant pressure-sensitive adhesive tape for the production of a semiconductor device, which is to be used by being adhered to a substrateless semiconductor chip which does not use a metal lead frame for temporarily fixing the chip in encapsulating the chip with a resin. The heat-resistant pressure-sensitive adhesive tape includes a base material layer and a pressure-sensitive adhesive layer formed on each side of the base material layer. At least the pressure-sensitive adhesive layer provided at a side on which a resin encapsulation is to be conducted contains a silicone pressure-sensitive adhesive. The pressure-sensitive adhesive layer at a side opposite the side on which the resin encapsulation is to be conducted may be a heat-expandable pressure-sensitive adhesive layer containing heat-expandable microspheres.
In the heat-resistant pressure-sensitive adhesive tape for the production of a semiconductor device, the heat-expandable pressure-sensitive adhesive layer may also employ a silicone pressure-sensitive adhesive.

The heat-resistant pressure-sensitive adhesive tape for the production of a semiconductor device of the present invention is described below.
Fig. 5 shows an embodiment of the heat-resistant pressure-sensitive adhesive tape 2 for the production of a semiconductor device used in the present invention. 10 is a smooth release sheet, 11 is a silicone pressure-sensitive adhesive layer, 12 is a base material layer, 13 is rubbery organic elastic layer, and 14 is a heat-expandable pressure-sensitive adhesive layer.

### Silicone pressure-sensitive adhesive layer 11

A silicone pressure-sensitive adhesive constituting the silicone pressure-sensitive adhesive layer 11 preferably has a storage modulus at 200°C of 5.0×10³ N/cm² or more, and the silicone pressure-sensitive adhesive layer 11 preferably has a thickness of from 2 to 50 μm. Furthermore, the silicone pressure-sensitive adhesive layer 11 preferably has an adhesive force after heating at 200°C according to JIS C2107 of from 0.05 to 4.0 N/20 mm width.
As the pressure-sensitive adhesive layer, there may be used an addition polymerization type silicone pressure-sensitive adhesive layer obtained by crosslinking an organopolysiloxane structure, preferably a dimethyl polysiloxane structure, using an unsaturated group such as vinyl group, and an SiH group, and then curing with a platinum catalyst, or a silicone pressure-sensitive adhesive obtained by curing with an organic peroxide such as BPO. Addition polymerization type one is preferred from the standpoint of heat resistance. In this case, crosslinking density can be adjusted according to the density of unsaturated group, considering adhesive force obtained.
Formation of the silicone pressure-sensitive adhesive layer is requires conducting heating or the like in order to conduct addition polymerization.
Regarding the adhesive force, where great difference occurs between the adhesive force to silicon and the adhesive force to a resin, there is a possibility that charging occurs due to the difference in adhesive forces. Therefore, those adhesive forces are required to be fallen in the above range from the standpoint that adhesive force values of those are desired to be as close as possible.
From the above standpoint, the silicone pressure-sensitive adhesive layer preferably has a 180° peel adhesive force to SUS304BA sheet at 175°C of 0.2 N/20 mm or more, and more preferably 0.5 N/20 mm or more. Furthermore, the silicone pressure-sensitive adhesive layer preferably has a 180° peel adhesive force to an encapsulation resin after heating at 175°C of 5.0 N/20 mm or less, and more preferably 3.0 N/20 mm or less.
The silicone pressure-sensitive adhesive layer has small heat expandability. Therefore, deviation of chip position after encapsulation with a resin is small. The extent of deviation is 0.3 mm or less, and preferably 0.1 mm or less.
In the case that the package is contaminated with a gas generated from the heat-resistant pressure-sensitive adhesive tape 2 for the production of a semiconductor device in the step of heat curing the encapsulation resin, reliability of package may be deteriorated (such as poor plating when rewiring). For this reason, weight loss at 180°C of the silicone pressure-sensitive adhesive layer 11 is preferably 3.0% by weight or less, and more preferably 2.0% by weight or less.
The silicone pressure-sensitive adhesive layer 11 preferably has a gel fraction of 30% by weight or more, more preferably 40% by weight or more, and still more preferably 50% by weight or more. When the silicone pressure-sensitive adhesive layer 11 has a gel fraction of 30% by weight or more, properties of the silicone pressure-sensitive adhesive layer are easily maintained in high temperature region, a wafer does not deviate when encapsulating with a resin, and adhesive residue does not occur to the encapsulation resin.
The silicone pressure-sensitive adhesive layer 11 may further include various additives generally used in the art of this field, such as a plasticizer, a pigment, a dye, an antioxidant, an antistatic agent, and a filler added to improve properties (for example, elastic modulus) of the pressure-sensitive adhesive layer 11. The amount of the additives added is not particularly limited so long as the amount does not impair appropriate adhesiveness.

### Base material layer 12

The kind of a material of the base material layer 12 is not particularly limited, but base materials having heat resistance under heating conditions when encapsulating with a resin are used. The resin encapsulation step generally requires a temperature of about 175°C. From this point, materials having such heat resistance that remarkable shrinkage does not occur under such temperature condition or the base material layer 12 itself does not collapse are preferably used. For this reason, the material preferably has a coefficient of liner thermal expansion at a temperature from 50 to 250°C of from 0.8×10⁻⁵ to 5.6×10⁻⁵/K.
When a base material having a glass transition temperature lower than a heating temperature at which the encapsulation resin is cured is used, a coefficient of linear expansion in a temperature region higher than the glass transition temperature is larger than that in a temperature region lower than the glass transition temperature, resulting in deterioration of accuracy from the designated position of the chip adhered.
In a monoaxially or biaxially stretched base material, elongation caused by stretching begins to shrink at a temperature higher than the glass transition temperature. This also leads to deterioration of accuracy from the designated position of the chip adhered. Therefore, in resin encapsulating a substrateless semiconductor chip which does not use a metal lead frame, when the glass transition temperature of the base material layer 12 used in the heat-resistant pressure-sensitive adhesive tape 2 for the production of a semiconductor device, which is to be used by being adhered to the chip, exceeds 180°C, positional accuracy of the chip can be improved.

Examples of the base material include heat-resistant plastic films such as polyethylene naphthalate (PEN) film, polyethylene sulfone (PES) film, polyether imide (PEI) film, polysulfone (PSF) film, polyphenylene sulfide (PPS) film, polyether ether ketone (PEEK) film, polyarylate (PAR) film, aramide film and liquid crystal polymer (LCP) film.
Polyethylene terephthalate (PET) film may also be used so long as the heating condition when encapsulating with a resin is 150°C or lower.

As the heat-resistant base material, there may be used paper base materials such as glassine paper, high quality paper and Japanese paper; and non-woven fabric base materials such as cellulose, polyamide, polyester and aramide; and metal film base materials such as aluminum foil, SUS foil and Ni foil. In addition, those materials may be laminated and used as the base material layer 12.
The base material layer 12 has a thickness at least of from 10 to 200 μm, and preferably from 25 to 100 μm, in order to prevent bending and tearing. Where the thickness thereof is less than 10 μm, handling properties are decreased. Thickness exceeding 200 μm leads to the increase in costs, which is not preferred.

### Rubbery organic elastic layer 13

The rubbery organic elastic layer 13 functions such that its surface well follows up a surface shape of an adherend in adhering the heat-resistant pressure-sensitive adhesive tape for the production of a semiconductor device to thereby provide a large contact area. In addition, when the heat-expandable pressure-sensitive adhesive layer 14 is foamed and/or expanded by heating the same in order to peel the adherend from the heat-resistant pressure-sensitive adhesive tape for the production of a semiconductor device, the rubbery organic elastic layer 13 functions so as to decrease the restriction of foaming and/or expansion in a planar direction of the heat-resistant pressure-sensitive adhesive tape for the production of a semiconductor device, to thereby assist waviness structure formation due to the change in three-dimensional structure of the heat-expandable pressure-sensitive adhesive layer 14.

In order to possess such properties, the rubbery organic elastic layer 13 preferably has a thickness of from 5 to 50 μm.
The rubbery organic elastic layer can be formed by natural rubber or synthetic rubber, or synthetic resin having rubber elasticity, having Shore D hardness according to ASTM D-2240 of preferably 50 or less, and more preferably 40 or less.

Examples of the synthetic rubber or synthetic resin include synthetic rubbers such as nitrile type, diene type and acryl type, thermoplastic elastomers such as polyolefin type and polyester type, and synthetic resins having rubber elasticity, such as an ethylene-vinyl acetate copolymer, polyurethane, polybutadiene and soft polyvinyl chloride. Substantially hard polymers such as polyvinyl chloride may be used in the present invention by combining the same with a compounding additive such as plasticizer or a softener, thereby imparting rubber elasticity to the hard polymer.
Furthermore, the rubbery organic elastic layer may be formed by conventional pressure-sensitive adhesives such as rubber-based pressure-sensitive adhesive and resin-based pressure-sensitive adhesive.

As the pressure-sensitive adhesive, there may be used appropriate pressure-sensitive adhesives such as rubber-based pressure-sensitive adhesive, acrylic pressure-sensitive adhesive and styrene/conjugated diene block copolymer-based pressure-sensitive adhesive. Pressure-sensitive adhesive which contains a hot-melt resin having a melting point of about 200°C or lower to improve creep properties may also be used.
The pressure-sensitive adhesive may contain appropriate additives such as an antistatic agent, a crosslinking agent, a tackifier, plasticizer, a filler and an age inhibitor.

More specifically, examples of the pressure-sensitive adhesive include rubber-based pressure-sensitive adhesives including natural rubber or synthetic rubber as a base polymer, and acrylic pressure-sensitive adhesives including, as a base polymer, an acrylic polymer including, as a main component, acrylic acid-based alkyl ester of acrylic acid or methacrylic acid, having an alkyl group having 20 or less carbon atoms such as methyl group, ethyl group, propyl group, butyl group, 2-ethylhexyl group, isooctyl group, isononyl group, isodecyl group, dodecyl group, lauryl group, tridecyl group, pentadecyl group, hexadecyl group, heptadecyl group, octadecyl group, nonadecyl group and eicosyl group; acrylic acid, methacrylic acid, itaconic acid, hydroxyethyl acrylate, hydroxyethyl methacrylate, hydroxypropyl acrylate, hydroxypropyl methacrylate, N-methylol acrylamide, acrylonitrile, methacrylonitrile, glycidyl acrylate, glycidyl methacrylate, vinyl acetate, styrene, isoprene, butadiene, isobutylene, and vinyl ether.

### Heat-expandable pressure-sensitive adhesive layer 14

The pressure-sensitive adhesive which forms the heat-expandable pressure-sensitive adhesive layer 14 is required to allow foaming and/or expansion of heat-expandable microspheres when heating, and there may be used conventional pressure-sensitive adhesives including, as a base, rubber material or (meth)acrylic resin that can be used in the rubbery organic elastic layer, and preferably pressure-sensitive adhesives having elasticity in an extent that does not restrict foaming and/or expansion of heat-expandable microspheres.
The polymer appropriately contains a tackifier such as conventional resins, a plasticizer, a pigment, a filler, a conducting agent, an antistatic agent or the like, and is crosslinked with a crosslinking agent such as a polyfunctional epoxy compound, an isocyanate compound, an aziridine compound, a melamine resin, a urea resin, anhydride compound, polyamine, or carboxyl-containing polymer.

The heat-expandable pressure-sensitive adhesive layer 14 can be formed by containing heat-expandable microspheres in a pressure-sensitive adhesive. Examples of the heat-expandable microspheres include heat-expandable microspheres obtained by covering an appropriate substance which easily gasifies and shows heat expandability, such as isobutene, propane or pentane, with a shell-forming substance by a coacervation method or an interfacial polymerization method. The heat-expandable microspheres desirably have a volume expansion ratio of 5 time or more, and preferably 10 times or more.
Examples of the shell-forming material which forms heat-expandable microspheres generally include a vinylidene chloride-acrylonitrile copolymer, polyvinyl alcohol, polyvinyl butyral, polymethyl methacrylate, polyacrylonitrile, polyvinylidene chloride and polysulfone. In the present invention, the shell-forming substance may be a hot-melt substance or a substance which collapses by heat expansion.

The amount of the foaming agent added is appropriately determined according to the extent of expanding (foaming the heat-expandable pressure-sensitive adhesive layer 14 or the extent of decreasing adhesive force. The foaming agent is added in an amount of generally from 1 to 150 parts by weight, and preferably from 25 to 100 parts by weight, per 100 parts by weight of the base polymer. The heat-expandable pressure-sensitive adhesive layer preferably has a thickness of from 5 to 80 μm, and more preferably from 15 to 50 μm.
The heat treatment condition to make that the heat-resistant pressure-sensitive adhesive tape 2 for the production of a semiconductor device of the present invention can easily be peeled from an adherend is determined by the conditions such as decreasing in adhering area due to a surface state of an adherend or kind of heat-expandable microspheres, heat resistance of a base material and an adherend, heating method, and the like. The general conditions are such that the heating temperature is from 100 to 250°C and the heating time is from 1 to 90 seconds (for example, hot plate) or from 5 to 15 minutes (for example, hot air drier). In the present application, since the resin encapsulation temperature is about 175°C, the heating conditions are desirably such that the heating temperature is from 200 to 250°C and the heating time is from 1 to 90 seconds (for example, hot plate) or from 1 to 15 minutes (for example, hot air drier).

### Smooth release sheet 10

The smooth release sheet 10 is a sheet including a base material film and a release agent layer formed on one side thereof, and is a sheet peeled to expose the pressure-sensitive adhesive layer on each face before using the heat-resistant pressure-sensitive adhesive tape 2 for the production of a semiconductor device of the present invention.
The release agent layer can be obtained by appropriately selecting from conventional release agent layers such as a long chain alkyl type, a fluorine rein type and a silicone resin type, according to the pressure-sensitive adhesive to be contacted therewith.

As the base material film, conventional films may be used and can be selected, for example, from plastic films such as polyether ether ketone film, polyether imide film, polyarylate film, polyethylene naphthalate film, polyethylene film, polypropylene film, polybutene film, polybutadiene film, polymethyl pentene film, polyvinyl chloride film, polyvinyl chloride copolymer film, polyethylene terephthalate film, polybutylene terephthalate film, polyurethane film, ethylene-vinyl acetate copolymer film, ionomer resin film, ethylene-(meth)acrylic acid copolymer film, ethylene-(meth)acrylic acid ester copolymer film, polystyrene film and polycarbonate film.
The release agent layer that can be used is a layer obtained by selecting an appropriate release agent from the conventional release agents such as fluorinated silicone resin-based release agent, fluorine resin-based release agent, silicone resin-based release agent, polyvinyl alcohol resin, polypropylene resin, and long chain alkyl compound, according to the resin of the pressure-sensitive adhesive layer, and containing the selected release agent in the resin.

### Production method of heat-resistant pressure-sensitive adhesive tape 2 for production of semiconductor device

The heat-resistant pressure-sensitive adhesive tape 2 for the production of a semiconductor device of the present invention can be produced by the general production methods. For example, compositions for constituting the silicone pressure-sensitive adhesive layer 11, and if necessary, the rubbery organic elastic layer 13 and the heat-expandable pressure-sensitive adhesive layer 14, respectively, are dissolved in a given solvent to prepare the respective coating liquids, the coating liquids are applied to a base material layer 12 so as to obtain a layer structure of the objective heat-resistant pressure-sensitive adhesive tape 2 for the production of a semiconductor device, and the resulting coating layer is then heated and dried under given conditions.

Further, a single film may be prepared by, for example, casting each solution of the compositions for constituting the silicone pressure-sensitive adhesive layer 11, the rubbery organic elastic layer 13 and the heat-expandable pressure-sensitive adhesive layer 14 on a releasable film or the like, and those films may be laminated on a base material in the order. Application of the coating liquid and lamination by of the films may be combined. The solvent used is not particularly limited. Considering that solubility of materials for constituting the silicone pressure-sensitive adhesive layer 11 is good, a ketone solvent such as methyl ethyl ketone is preferably used. There may also be used a method of forming a pressure-sensitive adhesive tape 2 for the production of a semiconductor device where the constituting materials are prepared made into an aqueous dispersion solution, the solution is applied to a base material layer 12, the resulting coating layer is heated and dried, and those procedures are repeated, thereby laminating silicone pressure-sensitive adhesive layers 11.

### Method of using heat-resistant pressure-sensitive adhesive tape for production of semiconductor device

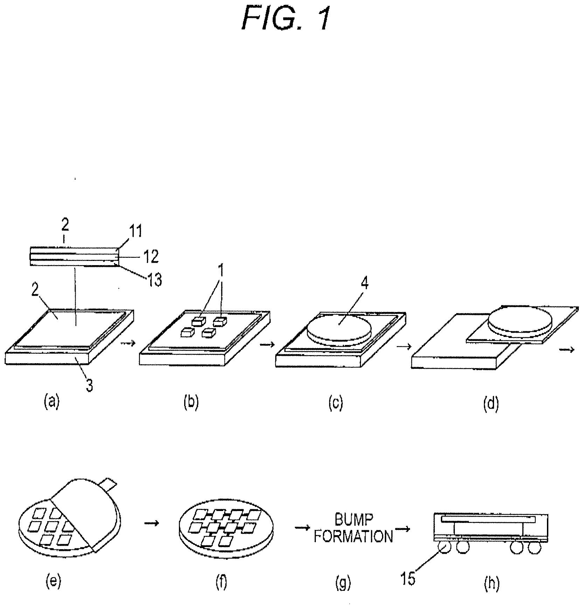

The heat-resistant pressure-sensitive adhesive tape 2 for the production of a semiconductor device is used in steps shown in Fig. 1 and Figs. 2A to 2F, and the like.

As an example, a summary of a process for producing a substrateless BGA is described below.
Fig. 1 is a view showing a method for producing a semiconductor device in which a substrateless semiconductor chip is encapsulated with a resin, the method employing the heat-resistant pressure-sensitive adhesive tape 2 for the production of a semiconductor device of the present invention.
In step (a), the heat-resistant pressure-sensitive adhesive tape 2 for the production of a semiconductor device of the present invention is adhered and fixed to the substrate 3. In step (b), semiconductor chips are adhered and fixed to the tape with an optional interval. In the subsequent step (c), semiconductor chips fixed are encapsulated with an encapsulation resin 4 so as to embed the chips.
In step (d), the plural chips thus encapsulated are peeled together with the encapsulation resin and the heat-resistant pressure-sensitive adhesive tape 2 for the production of a semiconductor device from the substrate by heat peeling. In step (e), the heat-resistant pressure-sensitive adhesive tape 2 for the production of a semiconductor device of the present invention is peeled from the resin-encapsulated semiconductor chips.
In step (f), various pattern printings are applied to an area between the semiconductor chips and the surfaces of the semiconductor chips to form a lead for wiring and the like. In the subsequent step (g), the lead for wiring forms a bump or the like which is a spherical connection electrode on the surface of the chip.
Finally, in step (h), an encapsulation resin part between the semiconductor chips is cut by dicing or the like, thereby each semiconductor device equipped with individual semiconductor chip(s) can be obtained.

The method is specifically described below with reference to Figs. 2A to 2F.

### Adhering step of semiconductor chip

The heat-expandable pressure-sensitive adhesive layer 14 side of the heat-resistant pressure-sensitive adhesive tape 2 for the production of a semiconductor device from which release sheets at both sides thereof have been removed is adhered to a substrate, and the silicone pressure-sensitive adhesive layer 11 side is exposed on the upper face.
Given semiconductor chips 1 to be encapsulated with a resin are placed on and adhered to the silicone pressure-sensitive adhesive layer 11 so as to obtain a given configuration, thereby fixing the chips to the silicone pressure-sensitive adhesive layer 11 of the heat-resistant pressure-sensitive adhesive tape 2 for the production of a semiconductor device. In this case, structure, shape, size and the like of the semiconductor chip 1 are not particularly limited.

### Encapsulation step

A resin used in an encapsulation step in which the heat-resistant pressure-sensitive adhesive tape 2 for the production of a semiconductor device of the present invention is used may be a conventional encapsulation resin such as epoxy resin. Melting temperature and curing temperature of a powdery resin, and curing temperature of a liquid resin are selected considering heat resistance of the heat-resistant pressure-sensitive adhesive tape 2 for the production of a semiconductor device. The heat-resistant pressure-sensitive adhesive tape 2 for the production of a semiconductor device of the present invention has heat resistance at the melting temperature and curing temperature of ordinary encapsulation resins.
The encapsulation step is conducted in a mold using the above resin for the purpose of protecting a chip, and is conducted at a temperature of, for example, from 170 to 180°C.
After peeling the heat-resistant pressure-sensitive adhesive tape 2 for the production of a semiconductor device, post-mold curing is conducted.

### Peeling step

After the chip fixed to the heat-resistant pressure-sensitive adhesive tape 2 for the production of a semiconductor device on the substrate is encapsulated with a resin, heating is conducted under the conditions at a temperature of from 200 to 250°C for a period of from 1 to 90 seconds (hot plate or the like) or for a period of from 1 to 15 minutes (hot air dryer) to expand the heat-expandable pressure-sensitive adhesive layer 14 of the heat-resistant pressure-sensitive adhesive tape 2 for the production of a semiconductor device, thereby decreasing adhesive force between the heat-expandable pressure-sensitive adhesive layer 14 of the heat-resistant pressure-sensitive adhesive tape 2 for the production of a semiconductor device and the substrate 3, and the heat-resistant pressure-sensitive adhesive tape 2 for the production of a semiconductor device and the substrate 3 are separated to each other.
Thereafter, the heat-resistant pressure-sensitive adhesive tape 2 for the production of a semiconductor device is peeled from the layer including chips encapsulated with a resin.
Alternatively, there may also be used a method where the heat-resistant pressure-sensitive adhesive tape 2 for the production of a semiconductor device and the substrate 3 are not separated to each other and maintain an integrated form, and plural chips I encapsulated with an encapsulation resin 4 are separated from the silicone pressure-sensitive adhesive layer of the heat-resistant pressure-sensitive adhesive tape 2 for the production of a semiconductor device.

### Electrode formation step

At a side of the layer including chips 1 encapsulated with a resin 4, on which the heat-resistant pressure-sensitive adhesive tape 2 for the production of a semiconductor device was laminated and a part of the surfaces of the chips 1 is exposed, an electrode 5 is formed on an given area of each chip by a method such as screen printing and a means for forming connection electrode in a protrudent form etc. Electrode material used may be a conventional material.

### Dicing step

The layer including chips 1 encapsulated with a resin 4 is fixed to a dicing sheet 8 preferably having a dicing ring 7, and is cut into each package using a dicing blade 6 used in an ordinary dicing step. In this case, when each chip 1 is not located at a given position, formation of an electrode becomes inaccurate and the position of the chip 1 in each package becomes inaccurate. In the worst case, there is a possibility that the dicing blade 6 contacts the chip 1 when conducting dicing.

When the heat-resistant pressure-sensitive adhesive tape 2 for the production of a semiconductor device of the present invention is used, the position of the chip 1 can be prevented from deviating in the encapsulation step with a resin 4. Therefore, the dicing step can smoothly be carried out without such a trouble, and as a result, a package in which a chip 1 is accurately located in the encapsulation resin can be obtained.
The present invention is described in more detail by reference to Examples, but it should be noted that the invention is not construed as being limited to the Examples.

### Examples

### EXAMPLE 1

As a heat-expandable pressure-sensitive adhesive composition, 1.0 part of an epoxy crosslinking agent, 5 parts of a rosin tackifier, 50 parts of a 200°C foaming/expansion type heat-expandable microspheres, and toluene were uniformly mixed with and dissolved in 100 parts of a copolymer including ethyl acrylate-butyl acrylate-acrylic acid (20 parts-80 parts-10 parts) to prepare a coating liquid.
As a silicone pressure-sensitive adhesive layer, an addition reaction type silicone pressure-sensitive adhesive (silicone rubber ratio/silicone resin ratio = 50/50), a platinum catalyst and toluene were uniformed mixed and dissolved to prepare a coating liquid. The coating liquid was applied to a 25 μm thick polyimide film (KAPTON 100H, manufactured by Du pont-Toray Co., Ltd.) as a base material layer so as to be in a thickness of 5 μm, and then dried. The heat-expandable pressure-sensitive adhesive composition prepared above was applied to the side of the base material layer to which the silicone pressure-sensitive adhesive was not applied, and then dried. Thus, a heat-resistant pressure-sensitive adhesive tape for the production of a semiconductor device having the heat-expandable pressure-sensitive adhesive layer having a thickness of about 40 μm was obtained.

After a heat-expandable pressure-sensitive adhesive side of the heat-resistant pressure-sensitive adhesive tape for the production of a semiconductor device was press bonded and fixed to a flat and smooth table, an Si wafer chip having a size of 5 mm × 5 mm was placed on the silicone pressure-sensitive adhesive face, and a powdery epoxy encapsulation resin (GE-7470LA, manufactured by Nitto Denko Corporation) was sprayed thereon, and molded at a temperature of 175°C under a pressure of 400 kPa for 2 minutes. The tape was heated at 150°C for 60 minutes to accelerate curing of the resin (post-mold curing). Thus, a package was prepared.
After preparation of the package, deviation distance of the chip from the initial position was measured with a digital microscope. The presence or absence of adhesive residue after peeling the heat-resistant pressure-sensitive adhesive tape for the production of a semiconductor device was visually confirmed.

### EXAMPLE 2

A package was prepared in the same manner as in Example 1, except that a coating liquid prepared by uniformly mixing and dissolving a coating liquid which was obtained by uniformly mixing and dissolving an addition reaction type silicone pressure-sensitive adhesive (silicone rubber ratio/silicone resin ratio = 70/30), a platinum catalyst and toluene, 50 parts of 200°C foaming expansion type heat-expandable microspheres, and toluene was used as the heat-expandable pressure-sensitive adhesive composition.

### COMPARATIVE EXAMPLE 1

A package was prepared in the same manner as in Example 1, except that a coating liquid prepared by uniformly mixing and dissolving an addition reaction type silicone pressure-sensitive adhesive (silicone rubber ratio/silicone resin ratio = 98/2), a platinum catalyst and toluene was used as the silicone pressure-sensitive adhesive layer.

### COMPARATIVE EXAMPLE 2

A package was prepared in the same manner as in Example 1, except that a coating liquid prepared by uniformly mixing and dissolving an addition reaction type silicone pressure-sensitive adhesive (silicone rubber ratio/silicone resin ratio =1 10/90), a platinum catalyst and toluene was used as the silicone pressure-sensitive adhesive layer.

### COMPARATIVE EXAMPLE 3

A package was prepared in the same manner as in Example 1, except that a pressure-sensitive adhesive composition obtained by adding 0.6 parts by weight of an epoxy crosslinking agent (Tetrad-C, manufactured by Mitsubishi Gas Chemical Company, Inc.) and 2 parts by weight of an isocyanate crosslinking agent (CORONATE L, manufactured by Nippon Polyurethane Industry Co., Ltd.) to 100 parts by weight of an acrylic copolymer including 100 parts by weight of butyl (meth)acrylate monomer and 3 parts by weight of (meth)acrylic acid monomer as a constituent monomer was used in place of the silicone pressure-sensitive adhesive layer.

### COMPARATIVE EXAMPLE 4

A package was prepared in the same manner as in Example 1, except that a pressure-sensitive adhesive composition obtained by adding 50 parts by weight of a phenol resin and 30 parts by weight of a metal crosslinking agent to 100 parts by weight of natural rubber was used in place of the silicone pressure-sensitive adhesive layer.

### COMPARATIVE EXAMPLE 5

A package was prepared in the same manner as in Example 1, except that a coating liquid obtained by uniformly mixing and dissolving 100 parts by weight of a copolymer including ethyl acrylate-butyl acrylate-acrylic acid (20 parts-80 parts-10 parts), 1.0 part by weight of an epoxy crosslinking agent (Tetrad-C, manufactured by Mitsubishi Gas Chemical Company, Inc.), 5 parts of a rosin-based tackifier and toluene was used as the heat-expandable pressure-sensitive adhesive layer.

### Results

In the heat-resistant pressure-sensitive adhesive tape for the production of a semiconductor device and the package prepared above, 180° peel adhesive force to SUS304BA sheet at 175°C (hereinafter referred to as "175°C adhesive force"), 180° peel adhesive force in actually peeling a heat-resistant pressure-sensitive adhesive tape for the production of a semiconductor device from a package (hereinafter referred to as "peeling force"), the value of deviation distance of a chip from initial position, and the presence or absence by visual observation with a microscope of adhesive residue after peeling heat-resistant pressure-sensitive adhesive tape for the production of a semiconductor device are shown in the Table 1 below.

**Table 1**

| | Unit | Example 1 | Example 2 | Comparative Example 1 | Comparative Example 2 | Comparative Example 3 | Comparative Example 4 | Comparative Example 5 |
|---|---|---|---|---|---|---|---|---|
| 175°C adhesive force to SUS304 | N/20 mm | 0.67 | 0.72 | 0.08 | 1.02 | 0.11 | 0.14 | 0.16 |
| Peeling force to package | N/20 mm | 1.34 | 2.48 | 1.11 | 6.01 | 8.88 | 7.73 | *1 |
| Deviation distance of chip | mm | 0.01 | 0.01 | 3.1 | 0.02 | 2.7 | 3.3 | *1 |
| Adhesive residue | - | None | None | None | Observed | Observed | Observed | *1 |

| | | | | | | | | |
|---|---|---|---|---|---|---|---|---|
| *1: Because heat-expandable microspheres were not contained in the heat-expandable pressure-sensitive adhesive layer, remarkable breakage of package was confirmed in recovering package after encapsulation. Due to the breakage, this item could not be measured. | | | | | | | | |

In Example 1, good package which was light peelable and was free of adhesive residue after peeling could be obtained by utilizing the characteristics of the silicone pressure-sensitive adhesive that deviation of chip was suppressed by having sufficient adhesive force when molding and adhesive force to an encapsulation resin was small.

In Example 2, because the 175° adhesive force was high similar to Example 1, deviation of a chip could be suppressed, and good package which was light peelable and was free of adhesive residue after peeling could be obtained.

In Comparative Example 1, a package which was light peelable and was free of adhesive residue after peeling could be obtained. However, because the silicone rubber ratio in the silicon pressure-sensitive adhesive was large, adhesive force was decreased and deviation of a chip could be not suppressed. This result indicates that deviation of a chip cannot be solved unless silicone rubber ratio/silicone resin ratio is optimized even though the silicone pressure-sensitive adhesive is present on resin encapsulation face.

In Comparative Example 2, deviation of a chip could be suppressed due to having sufficient adhesive force when molding. However, because the silicone rubber ratio in the silicone pressure-sensitive adhesive was small, cohesive force of the pressure-sensitive adhesive was decreased, adhesive force to a package was increased, and adhesive residue after peeling occurred. This result indicates that deviation of a chip cannot be solved unless silicone rubber ratio/silicone resin ratio is optimized even though the silicone pressure-sensitive adhesive is present on resin encapsulation face.

In Comparative Examples 3 and 4, deviation of a chip could not be suppressed due the decrease in adhesive force in high temperature region which was the characteristic of the acrylic pressure-sensitive adhesive and the rubber pressure-sensitive adhesive. This result indicates that deviation of a chip cannot be solved unless the silicone pressure-sensitive adhesive is used, even though only the base material layer has low degree of thermal expansion. Additionally, because adhesive force to a polyfunctional encapsulation resin is high, which is the characteristic of the acrylic pressure-sensitive adhesive and the rubber pressure-sensitive adhesive, peeling force is higher than that in the Examples, and adhesive residue after peeling occurred.

In Comparative Example 5, because the pressure-sensitive adhesive on the substrate face did not have heat peeling function, recovery of a package from the substrate was impossible, and the tape could not be used in the present process,

From the above results, the present invention can provide a heat-resistant pressure-sensitive adhesive tape for the production of a semiconductor device, for temporarily fixing a chip when producing a substrateless semiconductor package, which holds a chip in a resin encapsulation step and can reduce adhesive residue by the curing of the pressure-sensitive adhesive layer due to the subsequent heating treatment.

While the invention has been described in detail and with reference to specific embodiments thereof, it will be apparent to one skilled in the art that various changes and modifications can be made therein without departing from the scope thereof

This application is based on Japanese patent application No. 2010-206160 filed September 14, 2010, the entire contents thereof being hereby incorporated by reference.

## Claims

1. A heat-resistant pressure-sensitive adhesive tape for the production of a semiconductor device, which is to be used by being adhered to a substrateless semiconductor chip for temporarily fixing the chip in encapsulating the chip with a resin,
the tape comprising a base material layer and a pressure-sensitive adhesive layer formed on each side of the base material layer, wherein at least the pressure-sensitive adhesive layer at a side on which a semiconductor chip is to be encapsulated with a resin comprises a silicone pressure-sensitive adhesive.

2. The heat-resistant pressure-sensitive adhesive tape for the production of a semiconductor device according to claim 1, wherein the pressure-sensitive adhesive layer at a side on which a semiconductor chip is not to be encapsulated with a resin comprises a heat-expandable pressure-sensitive adhesive containing heart-expandable microspheres.

3. The heat-resistant pressure-sensitive adhesive tape for the production of a semiconductor device according to claim 1 or 2, wherein a ratio of a silicone rubber to a silicone resin in the silicone pressure-sensitive adhesive is from 95/5 to 20/80.

4. The heat-resistant pressure-sensitive adhesive tape for the production of a semiconductor device according to any one of claims 1 to 3, wherein the silicone pressure-sensitive adhesive in the pressure-sensitive adhesive layer at a side on which a semiconductor chip is to be encapsulated with a resin has a 180° peel adhesive force to SUS304BA sheet at 175°C of 0.2 N/20 mm or more.

5. The heat-resistant pressure-sensitive adhesive tape for the production of a semiconductor device according to any one of claims 1 to 4, wherein the silicone pressure-sensitive adhesive in the pressure-sensitive adhesive layer at a side on which a semiconductor chip is to be encapsulated with a resin has a 180° peel adhesive force to an encapsulation resin after heating at 175°C of 5.0 N/20 mm or less.

6. A method for producing a substrateless semiconductor device which does not use a metal lead frame, the method comprising using the heat-resistant pressure-sensitive adhesive tape for the production of a semiconductor device according to any one of claims 1 to 5.

7. The method for producing a semiconductor device according to claim 6, comprising:
(A) a step of adhering a support to the surface of the heat-expandable pressure-sensitive adhesive layer of the pressure-sensitive adhesive tape and adhering an adherend to the surface of the silicone pressure-sensitive adhesive layer;
(B) a step of processing the adherend;
(C) a step of peeling the pressure-sensitive adhesive tape from the support by a heat treatment; and
(D) a step of peeling the pressure-sensitive adhesive tape from the adherend after processing.
